# EUROPEAN PATENT APPLICATION

(11) **EP 4 386 041 A1**
(43) Date of publication of application: **19.06.2024**
(21) Application number: 21953523.4
(22) Date of filing: 13.08.2021
(51) Int. Cl.: C08J 5/18, C08L 79/08, C08L 27/18, B32B 27/20, B32B 27/28, C09J 7/22, C09J 179/08, H05K 1/03

(54) **COMPOSITE POLYIMIDE SUBSTRATE, COMPOSITE POLYIMIDE COMPOSITION, AND PRINTED CIRCUIT BOARD USING SAME**

(71) Applicant: LG Electronics Inc., Yeongdeungpo-gu Seoul 07336 (KR)
(72) Inventor: KINO, Takashi, Tokyo 140--0002 (JP); YOU, Dongjoo, Seoul 06772 (KR); JOUNG, Jeayoul, Seoul 06772 (KR); LEE, Junseok, Seoul 06772 (KR); CHO, Seongmoon, Seoul 06772 (KR); LEE, Eungmin, Tokyo 140--0002 (JP)
(74) Representative: Vossius & Partner Patentanwälte Rechtsanwälte mbB
(86) International application number: PCT/KR2021/010775
(87) International publication number: WO 2023/017876

(57) **Abstract**

The present invention is applicable in the field of substrates for high-frequency circuits, and for example, relates to a composite polyimide substrate, a composite polyimide composition, and a printed circuit board using same. The composite polyimide substrate according to the present invention may include: a substrate main body including a polyimide of which at least a portion has been substituted with a polyester group; and polytetrafluoroethylene (PTFE) particles included in the substrate main body.

## Description

### [Technical Field]

The present disclosure is applicable to a field of a substrate for a high-frequency circuit, and, for example, relates to a composite polyimide substrate, a composite polyimide composition, and a printed circuit boards using the same.

### [Background]

With a development of society, miniaturization of a home appliance is in progress. In the miniaturization of the home appliance, an existence of a flexible printed circuit board (FPCB) cannot be overlooked.

A rigid printed circuit board (PCB) is used for a main board of the home appliance, and there is a need to connect many parts with the main board to provide various functions. In this case, the FPCB may contribute to the miniaturization via high connectivity thereof.

Recently, the Internet is able to be accessed wirelessly even outdoors, and a laptop computer and a smartphone are equipped with a radio wave reception function as standard.

Additionally, with an advancement of a communication technology, an Internet access speed is increasing. Currently, there is a transition from 4G to 5G, and an era of new high-speed communication using a GHz band is about to open in the future.

Until now, polyimide, a super heat-resistant polymer material, has been used as a material for the FPCB. A main reason polyimide has been used is that polyimide is excellent in dimensional stability with a copper foil used to form the circuit and in reverse heat resistance when mounting the parts.

However, polyimide had drawbacks of great polarization and water absorption rate resulted from a charge migration. Because of such drawbacks, there was a problem that a dielectric constant or a dielectric loss increases, resulting in an increased transmission loss.

Until now, the drawbacks of polyimide have not been a big problem because there has been no substitute that matches the advantages of polyimide, but in the era using the high-speed communication in the GHz band (after the 5G), the drawbacks of polyimide are starting to become a problem. In addition, as a material suitable for the high-speed communication in the GHz band has begun to be developed, a demand for ameliorating the drawbacks of polyimide is increasing.

Polyimide has been used as the standard FPCB material for several decades now. Polyimide is said to have high water absorbency and thus have poor dimensional stability because of the water absorption. However, to solve such problem, a FPCB manufacturer has designed the circuit taking into account a dimensional change resulted from the water absorption of polyimide.

Additionally, also in a solder mounting process, the problem caused by the water absorption has been solved by performing a drying process in advance. Because conditions optimized for physical properties of the polyimide material are set for the circuit formation process of the FPCB manufacturer, there is a major challenge of optimizing the conditions when changing the material to another material.

Therefore, there is a demand for a development of a new polyimide material that solves the problems of the great polarization and water absorption rate while maintaining the advantages of polyimide.

### [Summary]

### [Technical Problem]

The present disclosure is to provide a composite polyimide substrate, a composite polyimide composition, and a printed circuit board using the same that may resolve great dielectric polarization and water absorption rate of polyimide.

In addition, the present disclosure is to provide a composite polyimide substrate, a composite polyimide composition, and a printed circuit board using the same that may resolve great dielectric constant and water absorption rate while maintaining high heat resistance and dimensional stability of polyimide.

In addition, the present disclosure is to provide a composite polyimide substrate, a composite polyimide composition, and a printed circuit board using the same with low dielectric constant and low dielectric loss characteristics while maintaining high heat resistance and dimensional stability of polyimide.

In addition, the present disclosure is to provide a composite polyimide substrate, a composite polyimide composition, and a printed circuit board using the same using a polyimide material suitable for high-speed communication in a GHz band.

### [Technical Solutions]

To achieve the above purposes, as polytetrafluoroethylene (PTFE) particles are added to polyimide containing polyester (polyester imide), dimensional stability of polyimide may be maintained and low dielectric constant and low dielectric loss may be achieved.

As a first aspect to achieve the above purposes, a composite polyimide substrate of the present disclosure includes a substrate matrix containing polyimide at least partially substituted with polyester, and polytetrafluoroethylene (PTFE) particles contained in the substrate matrix.

The polyester may contain at least one of hydroquinone bis(trimellitate anhydride) (TAHQ) and bis-phenol bis(trimellitate anhydride) (BP-TME).

The polyimide may contain at least one of m-Tolidine and 2,2'-Bis(trifluoromethyl) benzidine (TFMB).

The PTFE particles may have a size in a range from 300 nm to 5 *µ*m.

The PTFE particles may have an average particle diameter in a range from 0.3 *µ*m to 1.0 *µ*m.

The PTFE particles may be contained in a content in a range from 40 to 80 wt% with respect to the polyimide at least partially substituted with the polyester.

The PTFE particles may be dispersed and distributed in the substrate matrix.

The PTFE particles may be dispersed and distributed in the substrate matrix by a fluorine-based surfactant.

The polyester and the polyimide may have substantially the same content in the polyimide at least partially substituted with the polyester.

As a second aspect to achieve the above purposes, a composite polyimide substrate of the present disclosure includes a first layer containing polyester, a second layer in contact with the first layer and containing polyimide, and polytetrafluoroethylene (PTFE) particles dispersed in at least one of the first layer and the second layer.

The first layer and the second layer may be cross-stacked.

The polyimide may contain 2,2-Bis[4-(4-aminophenoxy)phenyl]propane (BAPP).

The polyimide containing the BAPP may be used as an adhesive layer.

The polyester may contain at least one of hydroquinone bis(trimellitate anhydride) (TAHQ) and bis-phenol bis(trimellitate anhydride) (BP-TME).

As a third aspect to achieve the above purposes, a printed circuit board of the present disclosure includes a composite polyimide substrate including a substrate matrix containing polyimide at least partially substituted with polyester, and polytetrafluoroethylene (PTFE) particles contained in the substrate matrix, and a circuit pattern formed on the composite polyimide substrate.

As a fourth aspect to achieve the above purposes, a composite polyimide composition of the present disclosure includes polyester imide containing an acid anhydride with TAHQ or BP-TME ester and containing m-Tolidine or TFMB, and polytetrafluoroethylene (PTFE) particles contained in the polyester imide.

The PTFE particles may be contained in a content in a range from 40 to 80 wt% with respect to the polyester imide.

The PTFE particles may be dispersed and distributed in the polyester imide.

The acid anhydride and the polyester imide in the composition may have substantially the same content.

### [Advantageous Effects]

According to one embodiment of the present disclosure, following effects are obtained.

First, according to the embodiment of the present disclosure, the composite polyimide substrate, the composition, and the printed circuit board having the low dielectric constant and the low dielectric loss may be provided.

In addition, for use for the laminate in the printed circuit board, thermal expansion coefficient consistency (the dimensional stability) of the copper foil, the low linear expansion coefficient, and the adhesion to the copper foil may be satisfied.

In addition, the composite polyimide substrate, the composition, and the printed circuit board that contain polyimide related to the signal in the GHz band, and especially, are able to be used for the flexible printed circuit board because of the low dielectric constant, the low dielectric loss, the thermal expansion coefficient consistency (the dimensional stability) of the copper foil, the low linear expansion coefficient, and the adhesion to the copper foil.

Furthermore, in accordance with the embodiment of the present disclosure, there are also additional technical effects not mentioned herein. Those of ordinary skill in the art may understand this through the present document and drawings.

### [Brief Description of the Drawings]

FIG. 1 is a conceptual diagram illustrating a composite polyimide substrate according to an embodiment of the present disclosure.
FIG. 2 is a schematic cross-sectional view illustrating a composite polyimide substrate according to another embodiment of the present disclosure.
FIG. 3 is a graph illustrating a frequency band to which a composite polyimide substrate according to an embodiment of the present disclosure is applied.
FIGS. 4 and 5 are schematic views illustrating a phenomenon when an AC signal passes through a general dielectric.
FIGS. 6 to 11 are photographs according to respective Present Examples of a composite polyimide substrate of the present disclosure.
FIG. 12 is a schematic cross-sectional view illustrating an example of a printed circuit board to which a composite polyimide substrate according to an embodiment of the present disclosure is applied.
FIG. 13 is a schematic cross-sectional view illustrating another example of a printed circuit board to which a composite polyimide substrate according to an embodiment of the present disclosure is applied.

### [Detailed Description]

Reference will now be made in detail to embodiments of the present disclosure, examples of which are illustrated in the accompanying drawings. Wherever possible, the same reference numbers will be used throughout the drawings to refer to the same or like parts, and redundant description thereof will be omitted. As used herein, the suffixes "module" and "unit" are added or used interchangeably to facilitate preparation of this specification and are not intended to suggest distinct meanings or functions.

In describing embodiments disclosed in this specification, relevant well-known technologies may not be described in detail in order not to obscure the subject matter of the embodiments disclosed in this specification. In addition, it should be noted that the accompanying drawings are only for easy understanding of the embodiments disclosed in the present specification, and should not be construed as limiting the technical spirit disclosed in the present specification.

Furthermore, although the drawings are separately described for simplicity, embodiments implemented by combining at least two or more drawings are also within the scope of the present disclosure.

In addition, when an element such as a layer, region or module is described as being "on" another element, it is to be understood that the element may be directly on the other element or there may be an intermediate element between them.

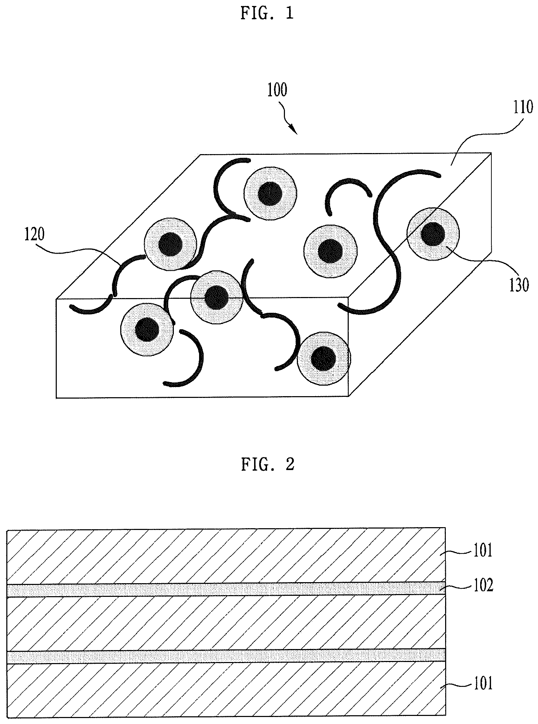

FIG. 1 is a conceptual diagram illustrating a composite polyimide substrate according to an embodiment of the present disclosure.

Referring to FIG. 1, a composite polyimide substrate 100 may include a substrate matrix 110 containing a low-k dielectric 120, and polytetrafluoroethylene (PTFE) particles 130 contained in the substrate matrix 110.

The substrate matrix 110 may contain polyimide, at least a portion of which is substituted with the low-k dielectric 120.

In this regard, polyimide may contain at least one of m-toluidine and 2,2'-Bis(trifluoromethyl) benzidine (TFMB).

The low-k dielectric 120 having a low-k dielectric constant may include polyester. In this case, polyester may contain at least one of hydroquinone bis(trimellitate anhydride) (TAHQ) and bis-phenol bis(trimellitate anhydride) (BP-TME).

The multiple PTFE particles 130 may be contained in the substrate matrix 110. The multiple PTFE particles 130 may be dispersed and distributed in the substrate matrix 110.

Such multiple PTFE particles 130 may be dispersed and distributed in the substrate matrix 110 by being dispersed by a fluorine-based dispersant. Specifically, the multiple PTFE particles 130 may be dispersed and distributed in the substrate matrix 110 by a fluorine-based surfactant.

The PTFE particles 130, which are a kind of fluorine resin, have very low water absorbency and thus have excellent dimensional stability. In addition, because a dielectric polarization is low and a dielectric constant and a dielectric loss are low, a transmission loss in a GHz band used for high-speed communication is also low.

Accordingly, because of the PTFE particles 130 dispersed and distributed in the substrate matrix 110, the low dielectric constant, low dielectric loss, and low transmission loss characteristics may be imparted to the composite polyimide substrate 100.

In this regard, the PTFE particles 130 may have a size in a range from 300 nm to 5 *µ*m. When the size of the PTFE particles 130 is equal to or smaller than 300 nm, a size of contained fluorine is small, and thus, the low dielectric effect may be insignificant. In addition, when the size of the PTFE particles 130 is equal to or greater than 5 *µ*m, blurring or a problem in straightness may occur during a laser drilling operation in a manufacturing process.

In addition, an average particle diameter of the PTFE particles 130 may be in a range from 0.3 to 1.0 *µ*m.

More specifically, the average particle diameter of the PTFE particles 130 may be in a range from 0.4 to 0.9 *µ*m.

A content of the PTFE particles 130 as such may be in a range from 40 to 80 wt% with respect to the substrate matrix 110.

For example, the content of the PTFE particles 130 may be in the range from 40 to 80 wt% with respect to polyimide, at least the portion of which constituting the substrate matrix 110 is substituted with polyester.

More specifically, the content of the PTFE particles 130 may be in a range from 50 to 70 wt% with respect to the substrate matrix 110.

A proportion of polyimide substituted with polyester in the substrate matrix 110 may be variously adjusted. For example, a ratio of polyester and polyimide in the substrate matrix 110 may be substantially 1:1. In this regard, the term "substantially" may mean that an error range is included.

That is, in polyimide, at least the portion of which is substituted with polyester, polyimide and polyimide may have substantially the same content.

As described above, polyimide related to a GHz band signal, especially polyimide to be used for a flexible printed circuit board, requires the low dielectric constant and the low dielectric loss. In addition, for use for a laminate, a thermal expansion coefficient consistency (the dimensional stability) (about 18 ppm) of a copper foil, and adhesion to the copper foil (equal to or greater than 1 kg/cm) are required.

The composite polyimide substrate 100 according to the embodiment of the present disclosure described above may satisfy such requirements.

That is, the composite polyimide substrate 100 having the above-described characteristics may maintain the dimensional stability of polyimide, and may achieve the low dielectric constant and the low dielectric loss. In addition, the composite polyimide substrate 100 having the above-described characteristics may obtain a low linear expansion coefficient and a high strength of the adhesion to the copper foil.

A composite polyimide composition for manufacturing the composite polyimide substrate 100 according to the present disclosure as described above may contain polyester imide containing an acid anhydride having a TAHQ or BP-TME ester group and m-toluidine or TFMB, and the polytetrafluoroethylene (PTFE) particles contained in polyester imide.

In this regard, the PTFE particles 130 may have the size in the range from 300 nm to 5 *µ*m. When the size of the PTFE particles 130 is equal to or smaller than 300 nm, the size of contained fluorine is small, and thus, the low dielectric effect may be insignificant. In addition, when the size of the PTFE particles 130 is equal to or greater than 5 *µ*m, the blurring or the problem in the straightness may occur during the laser drilling operation in the manufacturing process.

In addition, the average particle diameter of the PTFE particles 130 may be in the range from 0.3 to 1.0 *µ*m.

More specifically, the average particle diameter of the PTFE particles 130 may be in the range from 0.4 to 0.9 *µ*m.

The content of the PTFE particles 130 as such may be in the range from 40 to 80 wt% with respect to polyester imide.

More specifically, the content of the PTFE particles 130 may be in the range from 50 to 70 wt% with respect to polyester imide.

A proportion of polyimide substituted with polyester in polyester imide may be variously adjusted. For example, a ratio of polyester and polyimide in polyester imide may be substantially 1:1. In this regard, the term "substantially" may mean that an error range is included.

That is, in polyimide, at least the portion of which is substituted with polyester, polyimide and polyimide may have substantially the same content.

FIG. 2 is a schematic cross-sectional view illustrating a composite polyimide substrate according to another embodiment of the present disclosure.

Referring to FIG. 2, the composite polyimide substrate 100 may include a first layer 101 containing polyester and a second layer 102 in contact with the first layer 101 and containing polyimide.

Although not shown in FIG. 2, at least one of the first layer 101 and the second layer 102 may contain the multiple PTFE particles 130 (see FIG. 1). Such multiple PTFE particles 130 may be dispersed and distributed in at least one of the first layer 101 and the second layer 102.

As described above, such multiple PTFE particles 130 may be dispersed and distributed in at least one of the first layer 101 and the second layer 102 by being dispersed in at least one of the first layer 101 and the second layer 102. Specifically, the multiple PTFE particles 130 may be dispersed and distributed in at least one of the first layer 101 and the second layer 102 by the fluorine-based surfactant.

The PTFE particles 130, which are the kind of fluorine resin, have very low water absorbency and thus have excellent dimensional stability. In addition, because the dielectric polarization is low and the dielectric constant and the dielectric loss are low, the transmission loss in the GHz band used for the high-speed communication is also low.

Accordingly, because of the PTFE particles 130 dispersed and distributed in at least one of the first layer 101 and the second layer 102, the low dielectric constant, low dielectric loss, and low transmission loss characteristics may be imparted to the composite polyimide substrate 100.

In this regard, the PTFE particles 130 may have the size in the range from 300 nm to 5 *µ*m. When the size of the PTFE particles 130 is equal to or smaller than 300 nm, the size of contained fluorine is small, and thus, the low dielectric effect may be insignificant. In addition, when the size of the PTFE particles 130 is equal to or greater than 5 *µ*m, the blurring or the problem in the straightness may occur during the laser drilling operation in the manufacturing process.

In addition, the average particle diameter of the PTFE particles 130 may be in the range from 0.3 to 1.0 *µ*m.

A content of the PTFE particles 130 as such may be in a range from 0 to 80 wt% with respect to each or an entirety of the first layer 101 and the second layer 102.

For example, the content of the PTFE particles 130 may be in a range from 40 to 80 wt% with respect to the entirety of the first layer 101 and the second layer 102.

In this case, the first layer 101 and the second layer 102 may be cross-stacked. In FIG. 2, the two second layers 102 positioned between the three first layers 101 are illustrated, but the present disclosure is not limited thereto.

Polyimide contained in the second layer 102 may contain 2,2-Bis[4-(4-aminophenoxy)phenyl]propane(BAPP).

The second layer 102 containing polyimide containing BAPP as such may be used as an adhesive layer. Thus, the second layer 102 may be located between the two first layers 101. Relative thicknesses of the first layer 101 and the second layer 102 shown in FIG. 2 are merely illustrative. That is, the relative thicknesses of the first layer 101 and the second layer 102 may be different from those shown in FIG. 2.

For example, the thicknesses of the first layer 101 and the second layer 102 may be equal to each other. As another example, a total thickness of the first layers 101 and a total thickness of the second layers 102 in the composite polyimide substrate 100 may be substantially equal to each other.

Polyester contained in the first layer 101 may contain at least one of hydroquinone bis(trimellitate anhydride) (TAHQ) and bis-phenol bis(trimellitate anhydride) (BP-TME).

The composite polyimide substrate 100 having the above-described characteristics may maintain the dimensional stability of polyimide, and may achieve the low dielectric constant and the low dielectric loss. In addition, the composite polyimide substrate 100 having the above-described characteristics may obtain the low linear expansion coefficient and the high strength of the adhesion to the copper foil.

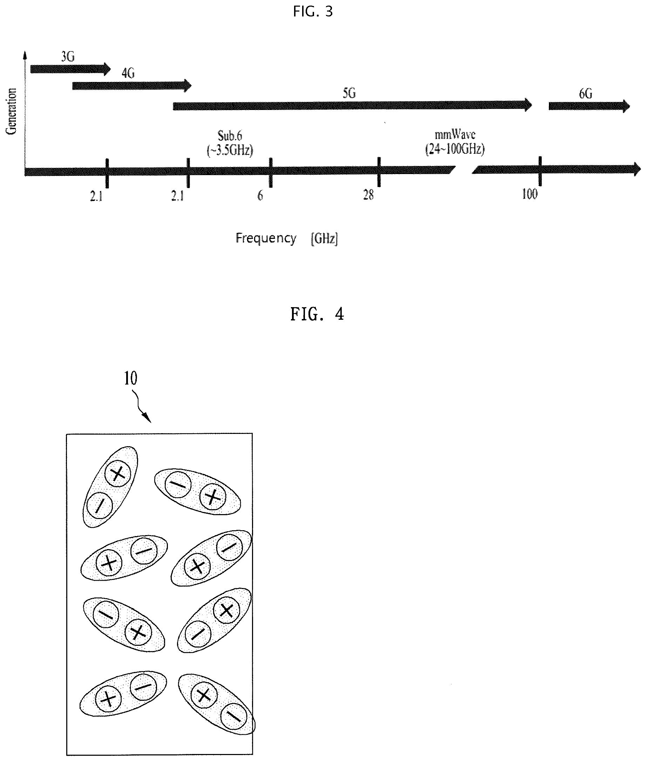

FIG. 3 is a graph illustrating a frequency band to which a composite polyimide substrate according to an embodiment of the present disclosure is applied.

With a development of a communication technology, an Internet access speed is gradually increasing. Currently, there is a transition from 4G to 5G, and an era of the new high-speed communication using the GHz band is about to open in the future. As shown in FIG. 3, a 5G standard may have a millimeter (mm) wavelength, which may correspond to a frequency in a range from about 24 GHz to about 100 GHz.

Until now, polyimide, a super heat-resistant polymer material, has been used as a material for the FPCB. A reason polyimide has been used is that polyimide is excellent in the dimensional stability with the copper foil used to form a circuit and in reverse heat resistance when mounting the parts.

However, polyimide had drawbacks of great polarization and water absorption rate resulted from a charge migration. Because of such drawbacks, there was a problem that a dielectric constant or a dielectric loss increases, resulting in an increased transmission loss.

Such problem has become more highlighted in the era using the high-speed communication in the GHz band (after the 5G). In addition, as a material suitable for the high-speed communication in the GHz band has begun to be developed, a demand for ameliorating the drawbacks of polyimide is increasing.

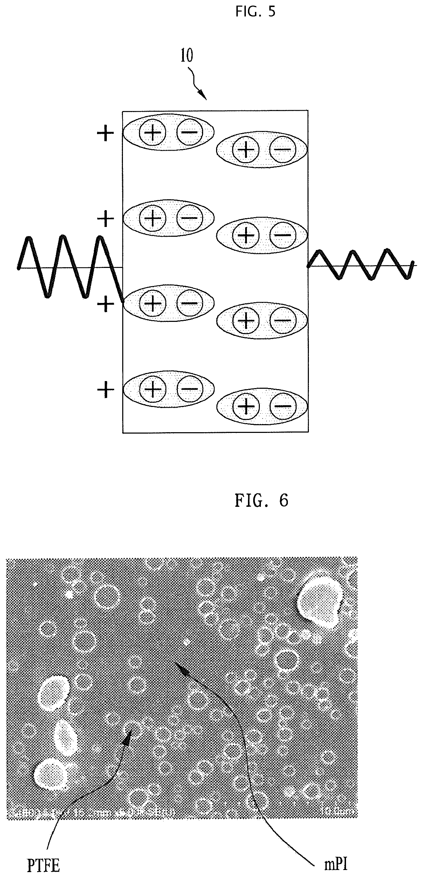

FIGS. 4 and 5 are schematic views illustrating a phenomenon when an AC signal passes through a general dielectric.

When there is no signal as shown in FIG. 4, electrons (-) and protons (+) in the dielectric 10 are bound, but freely distributed in terms of directionality. However, when the AC signal is applied to the dielectric 10, as shown in FIG. 5, a dielectric polarization in which the electrons (-) and the protons (+) in the dielectric 10 are aligned may occur, and in this process, a signal loss may occur. Such signal loss may be converted into other energy forms, such as heat, within the dielectric 10.

In general, the signal loss in the dielectric is proportional to the product of frequency, dielectric loss, and square root of dielectric constant, and electrode loss may be added thereto (signal loss∝(frequency x √dielectric constant) x dielectric loss) + electrode loss).

Specifically, the dielectric constant is a degree to which energy is absorbed by the dielectric when the AC signal passes through the dielectric, and represents a relative numeric value without units based on a value of 1 in vacuum. The dielectric loss refers to energy that is absorbed by the dielectric and converted into heat when the AC signal passes through the dielectric. In addition, the electrode loss refers to a loss caused by surface roughness because of a phenomenon in which the AC signal (current) flows to a surface when passing through an electrode, and a depth at which the current flows from the surface is 2.1 mm in the 4G band and is 0.4 mm in the 5G mmWave band.

Until now, polyimide has been used as the standard FPCB material for several decades now. Polyimide is said to have high water absorbency and thus have poor dimensional stability because of the water absorption. However, to solve such problem, a FPCB manufacturer has designed the circuit taking into account a dimensional change resulted from the water absorption of polyimide.

Additionally, also in a solder mounting process, the problem caused by the water absorption has been solved by performing a drying process in advance. Because conditions optimized for physical properties of the polyimide material are set for the circuit formation process of the FPCB manufacturer, there is a major challenge of optimizing the conditions when changing the material to another material.

Therefore, there is a demand for a development of a new polyimide material that solves the problems of the great polarization and water absorption rate while maintaining the advantages of polyimide.

What is expected as a substitute for polyimide is a liquid crystal polymer (LCP) and the fluorine resin. The liquid crystal polymer and the fluorine resin are representative resins with little water absorbency, and have excellent dimensional stability against the water absorption. In addition, because the polarization is not great and the dielectric constant and the dielectric loss are low, the transmission loss in the GHz band used for the high-speed communication is not great. In fact, the LCP or the fluorine resin has been used for an antenna circuit for a smartphone and a PCB of a communication base station.

However, the LCP and the fluorine resin are expensive because they are not being mass-produced, and the fluorine resin is difficult to be used as the base material for the FPCB because of poor flexibility thereof.

In addition, because the LCP also has higher anisotropy than polyimide, dimensional stability in a Z-axis direction thereof is good, and adhesion thereof to the copper foil also needs to be improved.

Because of such situation, there is a need for an improved polyimide material with physical properties equivalent to those of standard polyimide that maintains the advantages of the existing polyimide material and ameliorates the great polarization and water absorption rate.

The amelioration of the great polarization and water absorption rate of polyimide has been discussed a lot so far. As a main cause, the migration of the charges composed of donors and acceptors causes the great polarization, resulting in the increased water absorption rate. Accordingly, such defects may be solved by reducing a concentration of imide groups that cause the charge migration.

However, because high heat resistance and the dimensional stability were maintained by an influence of a great interaction of the charge migration derived from the imide groups, the high heat resistance and the dimensional stability, which were advantages, are lost by reducing the concentration of the imide groups. Therefore, balancing the concentration of the imide groups and what to replace the imide groups with become important factors.

What is expected herein is an ester group. The ester group is a basic skeleton of the LCP. Substituting the imide groups with the ester groups is the same as creating a hybrid of polyimide and the LCP. However, it is not a simple matter of replacing all of the imide groups with the ester groups.

Because the ester group does not have as high a polarization rate as the imide group and does not cause the charge migration, a force of an interaction between molecules is not as great as that of the imide group. Therefore, replacing all of the imide groups with the ester groups simply creates the LCP, so that all the advantages of the imide group may be lost.

According to the present disclosure, as described above, by dispersing the polytetrafluoroethylene (PTFE) particles in polyimide partially substituted with polyester, the dimensional stability may be maintained and the low dielectric constant and the low dielectric loss equivalent to those of the LCP may be achieved.

That is, the composite polyimide substrate 100 according to the embodiment of the present disclosure having the characteristics described above may maintain the dimensional stability of polyimide and achieve the low dielectric constant and the low dielectric loss. In addition, the composite polyimide substrate 100 having the characteristics described above may achieve the low linear expansion coefficient and the high strength of the adhesion to the copper foil.

Hereinafter, each Present Example of preparing compositions will be described. A representative Present Example is described as Present Example 1. In remaining Present Examples, contents of raw materials and the PTFE particles are changed as shown in Table 1. In addition, Comparative Examples to be compared with such Present Examples will be described. Each Comparative Example is as shown in Table 2.

### <Present Example 1>

A flow continues by introducing nitrogen into a 1 L glass reactor.

Thereafter, DMAc (N,N Dimethyl acetamide) is added into the reactor and started to be stirred. M-Tolidine is added to the reactor and continues to be stirred until completely dissolved.

Thereafter, BP-TME (Bis-phenol bis(trimellitate anhydride)) is added and a temperature is raised to 50 °C. The stirring continues at a solid concentration of 16 wt% and a molar ratio of BP-TME/m-Tolidine = 0.995. A polyamic acid solution with a final viscosity of 2000 poise is obtained.

An NMP (N-Methyl-2-Pyrrolidone) solution in which the PTFE particles are dispersed is mixed with this polyamic acid solution such that a concentration thereof is 40 wt% with respect to the polyamic acid solution, and continue to be stirred.

The polyamic acid solution is applied to a glass substrate, dried at 160 °C for 5 minutes, then removed from the glass substrate and fixed to a monitor fixing substrate.

Such removed entity is dried in an electric furnace to produce a composite polyimide film.

### <Present Example 2>

It is substantially the same as Present Example 1, but a difference is that the NMP solution in which the PTFE particles are dispersed is mixed at a concentration of 60 wt% with respect to the polyamic acid solution.

### <Present Examples 3 to 12>

Composite polyimide films are manufactured in the same manner by changing the contents of the raw materials and the PTFE particles as shown in Table 1.

### <Comparative Examples 1 to 9>

Composite polyimide film are manufactured in the same manner by changing the contents of the raw materials and the PTFE particles as shown in Table 2.

**[Table 1]**

| **Present Example** | **Polyester imide** | | | | **PTFE Powde r** | **Dk*** | **Df*** | **CTE** | **Tg** |
|---|---|---|---|---|---|---|---|---|---|
| | **Dianhydride** | | **Diamine** | | | | | | |
| | **TAH Q** | **BP-TME** | **m-Tolidi ne** | **TFMB** | | | | | |
| **Unit** | **Mole%** | | **Mole%** | | **wt%** | **-** | **-** | **ppm** | **DegC** |
| **1** | | **100** | **100** | | **40** | **2.9** | **0.0030** | **10** | **350** |
| **2** | | **100** | **100** | | **60** | **2.7** | **0.0022** | **13** | **350** |
| **3** | | **100** | **100** | | **80** | **2.6** | **0.0022** | **16** | **350** |
| **4** | | **100** | | **100** | **40** | **2.5** | **0.0023** | **19** | **350** |
| **5** | | **100** | | **100** | **60** | **2.3** | **0.0021** | **19** | **350** |
| **6** | | **100** | | **100** | **80** | **2.3** | **0.0021** | **19** | **350** |
| **7** | **100** | | **100** | | **40** | **3.0** | **0.0031** | **16** | **350** |
| **8** | **100** | | **100** | | **60** | **2.8** | **0.0022** | **19** | **350** |
| **9** | **100** | | **100** | | **80** | **2.8** | **0.0022** | **19** | **350** |
| **10** | **100** | | | **100** | **40** | **2.6** | **0.0024** | **19** | **350** |
| **11** | **100** | | | **100** | **60** | **2.4** | **0.0022** | **19** | **350** |
| **12** | **100** | | | **100** | **80** | **2.4** | **0.0022** | **19** | **350** |

**[Table 2]**

| Comparat ive Example | **Polyester imide** | | | | | **PTFE Powder** | **Dk*** | **Df*** | **CTE** | **Tg** |
|---|---|---|---|---|---|---|---|---|---|---|
| | **Dianhydride** | | | **Diamine** | | | | | | |
| | **PMD A** | **TAH Q** | **BP-TME** | **m-Tolidine** | **TFM B** | | | | | |
| **Unit** | **Mole%** | | | **Mole%** | | **wt%** | **-** | **-** | **ppm** | **DegC** |
| **1** | | | **100** | **100** | | | **3.2** | **0.0027** | **10** | **350** |
| **2** | | | **100** | **100** | | **20** | **3.1** | **0.003** | **14** | **350** |
| **3** | | | **100** | | **100** | | **3.1** | **0.0027** | **16** | **350** |
| **4** | | **100** | | **100** | | | **3.1** | **0.0035** | **16** | **350** |
| **5** | | **100** | | **100** | | **20** | **3.0** | **0.004** | **18** | **350** |
| **6** | | **100** | | | **100** | | **3.2** | **0.0028** | **16** | **350** |
| **7** | **100** | | | **100** | | **3.2** | **3.2** | **0.01** | **16** | **350** |
| **8** | **100** | | | **100** | | **20** | **3.1** | **0.01** | **16** | **350** |
| **9** | **100** | | | **100** | | **40** | **3.0** | **0.01** | **16** | **350** |

In Table 1, for each Present Example (Unit), polyester (TAHQ or BP-TME) and polyimide (m-Tolidine or TFMB) in polyester imide are recorded in a molar ratio to mainly show relative proportions thereof, and a weight ratio (wt%) of the PTFE particles (PTFE Power) with respect to such polyester imide is recorded.

In Table 2, for each Comparative Example (Unit), PMDA, TAHQ, BP-TME, m-Tolidine, and TFMB are recorded in a molar ratio to mainly show a relative proportion of m-Tolidine or TFMB with respect to PMDA, TAHQ, or BP-TME, and a weight ratio (wt%) of the PTFE particles (PTFE Power) with respect to such polyester imide is recorded.

In Tables 1 and 2, Dk* represents the dielectric constant and Df* represents the dielectric loss. As such, it may be seen that, according to the Present Examples of the present disclosure, the dielectric constant and the dielectric loss are lowered compared to those in Comparative Examples.

In Tables 1 and 2, CTE represents the thermal expansion coefficient and Tg represents a glass temperature. Exceeding this temperature may mean that the film loses properties thereof and stretches.

Referring to Tables 1 and 2, it may be seen that, according to Present Examples, the thermal expansion coefficients (CTE) are higher than those of Comparative Examples.

FIGS. 6 to 11 are photographs according to respective Present Examples of a composite polyimide substrate of the present disclosure.

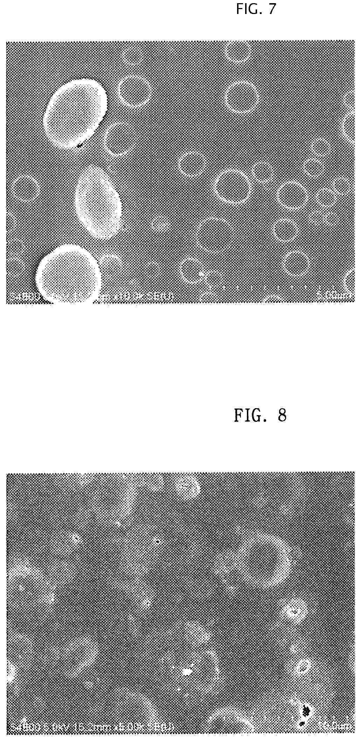

FIGS. 6 and 7 show photographs of a composite polyimide substrate composed of polyester (BP-TME) and polyimide (m-Tolidine) in a ratio of 1:1 and containing 20 wt% of the PTFE particles.

FIG. 6 shows a photograph magnified 5000 times, and FIG. 7 shows a photograph magnified 10000 times. In each photograph, circular particles represent the PTFE particles, and a remaining portion represents a portion of polyester imide (mPI) containing polyester (BP-TME) and polyimide (m-Tolidine).

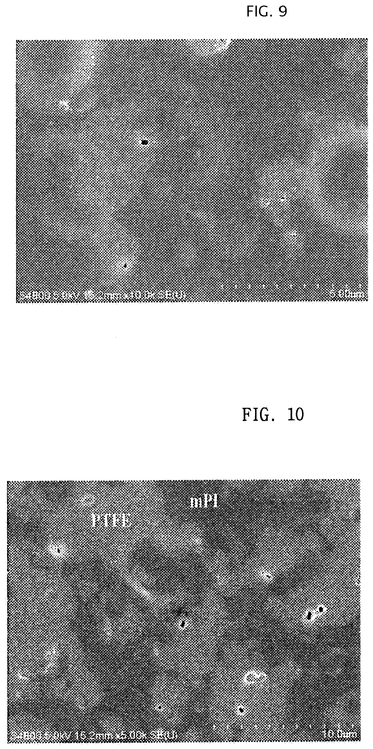

FIGS. 8 and 9 show photographs of a composite polyimide substrate composed of polyester (BP-TME) and polyimide (m-Tolidine) in a ratio of 1:1 and containing 40 wt% of the PTFE particles.

Likewise, FIG. 8 shows a photograph magnified 5000 times, and FIG. 9 shows a photograph magnified 10000 times. In each photograph, circular particles represent the PTFE particles, and a remaining portion represents a portion of polyester imide (mPI) containing polyester (BP-TME) and polyimide (m-Tolidine).

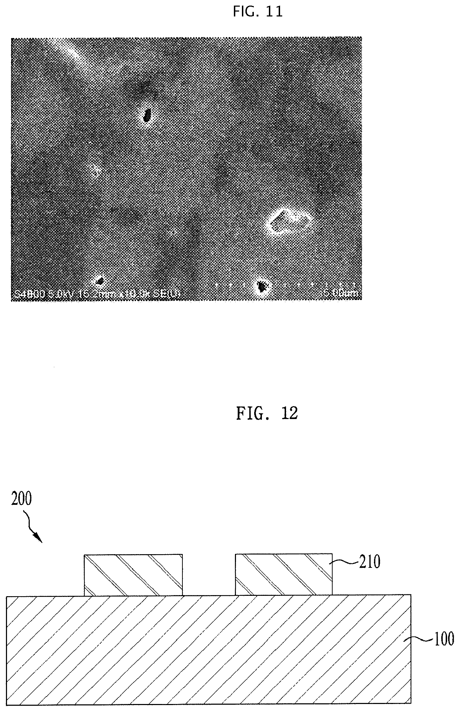

In addition, FIGS. 10 and 11 show photographs of a composite polyimide substrate composed of polyester (BP-TME) and polyimide (m-Tolidine) in a ratio of 1:1 and containing 60 wt% of the PTFE particles.

Likewise, FIG. 10 shows a photograph magnified 5000 times, and FIG. 11 shows a photograph magnified 10000 times. In each photograph, circular particles represent the PTFE particles, and a remaining portion represents a portion of polyester imide (mPI) containing polyester (BP-TME) and polyimide (m-Tolidine).

As seen in each photograph, the PTFE particles may be evenly dispersed in polyester imide (mPI) and exhibit the effects as described above.

That is, the PTFE particles may be evenly dispersed in polyester imide (mPI) by being stirred by the fluorine-based surfactant.

FIG. 12 is a schematic cross-sectional view illustrating an example of a printed circuit board to which a composite polyimide substrate according to an embodiment of the present disclosure is applied.

Referring to FIG. 12, a printed circuit board 200 with a circuit pattern 210 located on the composite polyimide substrate 100 is shown.

As described above, such composite polyimide substrate 100 may include the substrate matrix 110 containing polyimide, at least the portion of which is substituted with polyester, and the polytetrafluoroethylene (PTFE) particles contained in the substrate matrix 110.

The printed circuit board 200 with the circuit pattern 210 located on the composite polyimide substrate 100 may maintain the dimensional stability of polyimide and achieve the low dielectric constant and the low dielectric loss. In addition, the composite polyimide substrate 100 having the characteristics described above may achieve the low linear expansion coefficient and the high strength of the adhesion to the copper foil.

For other portions not described, the matters described above with reference to FIGS. 1 to 5 may be applied in the same manner.

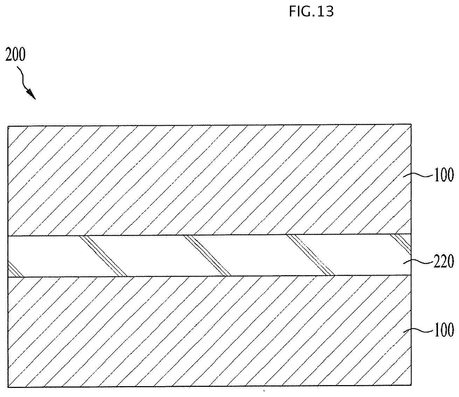

FIG. 13 is a schematic cross-sectional view illustrating another example of a printed circuit board to which a composite polyimide substrate according to an embodiment of the present disclosure is applied.

Referring to FIG. 13, a printed circuit board 200 with a circuit pattern 220 located between the composite polyimide substrates 100 is shown.

As described above, such composite polyimide substrate 100 includes the substrate matrix 110 containing polyimide, at least the portion of which is substituted with polyester, and the polytetrafluoroethylene (PTFE) particles contained in the substrate matrix 110.

For other portions not described, the matters described above with reference to FIGS. 1 to 5 may be applied in the same manner.

The above description is merely illustrative of the technical idea of the present disclosure. Those of ordinary skill in the art to which the present disclosure pertains will be able to make various modifications and variations without departing from the essential characteristics of the present disclosure.

Therefore, embodiments disclosed in the present disclosure are not intended to limit the technical idea of the present disclosure, but to describe, and the scope of the technical idea of the present disclosure is not limited by such embodiments.

The scope of protection of the present disclosure should be interpreted by the claims below, and all technical ideas within the scope equivalent thereto should be construed as being included in the scope of the present disclosure.

### [Industrial applicability]

According to the present disclosure, the composite polyimide substrate, the composite polyimide composition, and the printed circuit board using the same that are applicable to the field of the substrate for the high-frequency circuit may be provided.

## Claims

1. A composite polyimide substrate comprising:
a substrate matrix containing polyimide at least partially substituted with polyester; and
polytetrafluoroethylene (PTFE) particles contained in the substrate matrix.

2. The composite polyimide substrate of claim 1, wherein the polyester contains at least one of hydroquinone bis(trimellitate anhydride) (TAHQ) and bis-phenol bis(trimellitate anhydride) (BP-TME).

3. The composite polyimide substrate of claim 1, wherein the polyimide contains at least one of m-Tolidine and 2,2'-Bis(trifluoromethyl) benzidine (TFMB).

4. The composite polyimide substrate of claim 1, wherein the PTFE particles have a size in a range from 300 nm to 5 *µ*m.

5. The composite polyimide substrate of claim 1, wherein the PTFE particles have an average particle diameter in a range from 0.3 *µ*m to 1.0 *µ*m.

6. The composite polyimide substrate of claim 1, wherein the PTFE particles are contained in a content in a range from 40 to 80 wt% with respect to the polyimide at least partially substituted with the polyester.

7. The composite polyimide substrate of claim 1, wherein the PTFE particles are dispersed and distributed in the substrate matrix.

8. The composite polyimide substrate of claim 7, wherein the PTFE particles are dispersed and distributed in the substrate matrix by a fluorine-based surfactant.

9. The polyimide substrate of claim 1, wherein the polyester and the polyimide have substantially the same content in the polyimide at least partially substituted with the polyester.

10. A composite polyimide substrate comprising:
a first layer containing polyester;
a second layer in contact with the first layer and containing polyimide; and
polytetrafluoroethylene (PTFE) particles dispersed in at least one of the first layer and the second layer.

11. The composite polyimide substrate of claim 10, wherein the first layer and the second layer are cross-stacked.

12. The composite polyimide substrate of claim 10, wherein the polyimide contains 2,2-Bis[4-(4-aminophenoxy)phenyl]propane (BAPP).

13. The composite polyimide substrate of claim 12, wherein the polyimide containing the BAPP is used as an adhesive layer.

14. The composite polyimide substrate of claim 10, wherein the polyester contains at least one of hydroquinone bis(trimellitate anhydride) (TAHQ) and bis-phenol bis(trimellitate anhydride) (BP-TME).

15. A printed circuit board comprising:
a composite polyimide substrate including:
a substrate matrix containing polyimide at least partially substituted with polyester; and
polytetrafluoroethylene (PTFE) particles contained in the substrate matrix; and
a circuit pattern formed on the composite polyimide substrate.

16. The printed circuit board of claim 15, wherein the polyester contains at least one of hydroquinone bis(trimellitate anhydride) (TAHQ) and bis-phenol bis(trimellitate anhydride) (BP-TME).

17. The printed circuit board of claim 15, wherein the PTFE particles have a size in a range from 300 nm to 5 *µ*m*.*

18. The printed circuit board of claim 15, wherein the PTFE particles are contained in a content in a range from 40 to 80 wt% with respect to the polyimide constituting the substrate matrix and at least partially substituted with the polyester.

19. A composite polyimide composition comprising:
polyester imide containing an acid anhydride with TAHQ or BP-TME ester and containing m-Tolidine or TFMB; and
polytetrafluoroethylene (PTFE) particles contained in the polyester imide.

20. The composite polyimide composition of claim 19, wherein the PTFE particles have a size in a range from 300 nm to 5 *µ*m.

21. The composite polyimide composition of claim 19, wherein the PTFE particles have an average particle diameter in a range from 0.3 to 1.0 *µ*m.

22. The composite polyimide composition of claim 19, wherein the PTFE particles are contained in a content in a range from 40 to 80 wt% with respect to the polyester imide.

23. The composite polyimide composition of claim 19, wherein the PTFE particles are dispersed and distributed in the polyester imide.

24. The composite polyimide composition of claim 23, wherein the PTFE particles are dispersed and distributed in the substrate matrix by a fluorine-based surfactant.

25. The composite polyimide composition of claim 19, wherein the acid anhydride and the polyester imide in the composition have substantially the same content.
